# EUROPEAN PATENT APPLICATION

(11) **EP 4 791 168 A1**
(43) Date of publication of application: **12.08.2026**
(21) Application number: 25157276.4
(22) Date of filing: 11.02.2025
(51) Int. Cl.: H10K 85/20

(54) **CARBON-BASED CHARGE COLLECTOR WITH HIGH CONDUCTIVITY AND CARRIER SELECTIVITY**

(71) Applicant: ECOLE POLYTECHNIQUE FEDERALE DE LAUSANNE (EPFL), 1015 Lausanne (CH)
(72) Inventor: GRAETZEL, Michael, 1025 St-Sulpice (CH); ZHENG, Likai, 1022 Chavannes-Renens (CH); WANG, Minhuan, 1007 Lausanne (CH); JIANG, Xiaoqing, Qingdao City, 266000 (CN)
(74) Representative: ABREMA SA

(57) **Abstract**

This invention relates to a carbon-based composite comprising a carbon material, said composite acting as a selective contact for positive charges or for negative charges in a photovoltaic or an electronic device and to an optoelectronic or photovoltaic device comprising a light-harvesting layer (3) comprising an organic/inorganic metal halide perovskite, and a carbon-based electrode (4) comprising said carbon-based composite.

## Description

### Technical Field

The present invention relates to a carbon-based composite acting as a selective contact for positive charges or for negative charges and to a carbon-based electrode of a photovoltaic device, an optoelectronic device or an electronic device.

### Prior Art and the Problem Underlying the Invention

Perovskite solar cells (PSCs) have emerged as a promising photovoltaic technology due to their exceptional power conversion efficiencies (PCEs) and low fabrication costs. Despite these advantages, challenges associated with manufacturing complexity and device stability limits the large-scale commercialization of PSCs.

An important limitation concerns the fabrication of conventional PSCs, which typically involves vacuum-based techniques such as sputtering, evaporation, and atomic layer deposition (ALD) for depositing critical components like metal electrodes, charge transport layers, or interfacial layers. These vacuum-based processes, while highly effective for achieving uniform thin films and precise layer control, require sophisticated equipment, consume significant energy, and incur high operational costs. Additionally, reliance on such equipment limits scalability, particularly in regions or industries where access to advanced facilities is constrained.

Another critical limitation is the reliance on the organic hole transport material (HTM) Spiro-OMeTAD. This not only increases the cost of production, but also compromises the stability of the device due to its susceptibility to degradation under environmental conditions.

Traditional metal-based electrodes, typically made from materials like copper, silver or gold, offer high electrical conductivity but present challenges, in particular their chemical reactivity, high cost, scarcity or complex fabrication processes. Even gold, which is considered to be the most inert electronic contact materials, undergoes corrosion in the presence of halide or pseudo halide anions when used as a positive electrode in perovskite solar cells.

One of the key requirements for electronic contact materials to be suited for a wide range of energy technologies, in particular photovoltaic and light emitting devices, is their ability to extract and transport selectively either negative charges (electrons) or positive charges (holes). Carbon materials, known for their abundance, low cost, and tunable properties, have emerged as promising candidates for charge carrier collection. In particular, graphene as carbon material offers an attractive alternative as counter electrodes in PSCs due to their electrical conductivity, chemical stability, and tunable properties. Furthermore, their preparation using solution-based techniques, such as spin coating, spray coating, can eliminate the need for vacuum systems, significantly reducing the capital and operational expenditures associated with PSC production. However, integrating graphene into PSCs compromises charge transport efficiency. Conventional carbon electrodes often suffer from low conductivity and insufficient charge carrier selectivity, limiting their performance in advanced applications.

The present invention addresses the problems depicted above, such as the limitations associated with the manufacturing process including complex deposition steps and depending on sophisticated equipment limiting the scalability of the production of devices and then the decrease of production costs.

In addition to the development of advanced electronic charge collectors, new strategies for improving the efficiency of energy conversion devices and storage devices, such as solar cells and batteries as well as the device stability are necessary.

The present invention further addresses the problems associated with the use of effective but expensive HTM such as Spiro-OMeTAD and the corrosion of the metal-based electrodes.

The problems of the device instability, low conductivity and weak charge carrier selectivity due to the carbon-based electrodes used as back contact in PSCs as well as the device instability due to the long-term operation endured by PSCs are also addressed.

### Summary of the Invention

To address the problems depicted above, the present invention proposes to improve the efficiency and stability of photovoltaic and electronic devices by enhancing the selectivity of electric contact materials for charge carriers, namely for positive charges or for negative charges, and by enhancing the electrical conductivity of carbon material used as carbon electrode in photovoltaic and electronic devices.

To this effect, the present invention proposes a carbon-based composite combining carbon material and an additive that conducts positive charges (holes) or negative charges (electrons), said carbon-based composite acting as a selective contact for positive or negative charges in photovoltaic or electronic devices. The positive or negative charge conducting additive acts as an electrical conductivity enhancer of the carbon material. Thus, a carbon-based electrode comprising the carbon-based composite combines higher electrical conductivity with the ability to selectively transport charge carriers according to its ability to conduct either positive or negative charges. Furthermore, the use of the carbon-based composite in a carbon-based electrode allows the interface between the light-harvesting layer, i.e. the perovskite active layer, and the carbon-based electrode to be bridged, replacing the metal passivator metal contact in between in PSCs and the metal back contact of the solar cell. Thus, the carbon-based composite enables the fabrication of efficient PSCs which does not require a charge transport layer (CTL) between the light-harvesting or perovskite active layer and the back contact to be efficient and effective. In addition, the manufacture of the carbon-based electrode with the carbon-based composite allows the development of an effective all-solution process for the manufacture of such devices, simplifying the manufacturing process by replacing vacuum-dependent steps in the manufacturing process. This would lead to the production of more efficient and scalable energy conversion and storage devices.

According to one aspect, the present invention provides a carbon-based composite comprising a carbon material, said composite acting as a selective contact for positive charges or for negative charges in a photovoltaic or an electronic device.

In particular, the carbon-based composite further comprises an additive selected from a positive charge conducting additive or from a negative charge conducting additive.

In another aspect, the invention further provides an optoelectronic or photovoltaic device comprising a light-harvesting layer comprising an organic/inorganic metal halide perovskite, and a carbon-based electrode comprising a carbon-based composite.

Other features and advantages of the present invention are mentioned in the dependent claims as well as in the following detailed description disclosing, with reference to the figures, preferred embodiments of the invention in more detail.

### Brief Description of the Drawings

The attached figures exemplarily and schematically illustrate the principles as well as several embodiments of the present invention.
**Figure 1** is schema of an optoelectronic or photovoltaic device comprising a carbon-based composite as back contact 4 wherein the charge transport layer (CTL) 2 is an electron transport layer (ETL) according to one embodiment or a hole transport layer (HTL).
**Figure 2A** is schema of n-i-p perovskite solar according to one embodiment of the invention.
**Figure 2B** is schema of p-i-n perovskite solar. schematic diagram of a perovskite solar cell using a doped-carbon electrode comprising the carbon material graphene combined with Spiro-OMeTAD.
**Figure 3A** a schematic diagram of a PSC structure (n-i-p perovskite solar cell) with an enlarged schematic diagram of the interface between the perovskite layer and a carbon electrode comprising "traditional carbon", i.e. a carbon material without a positive or negative charge conducting additive, or a carbon electrode comprising "new carbon", i.e. a carbon-based composite comprising a hole shuttle molecule (HSM).

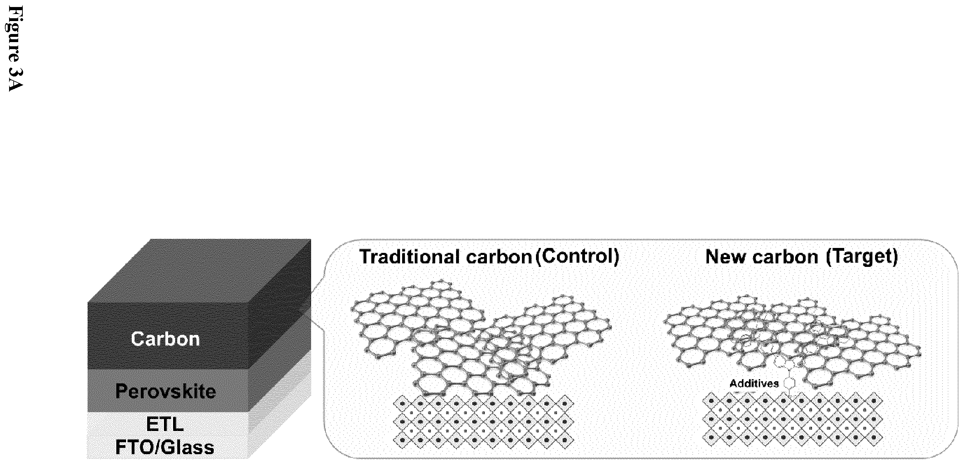

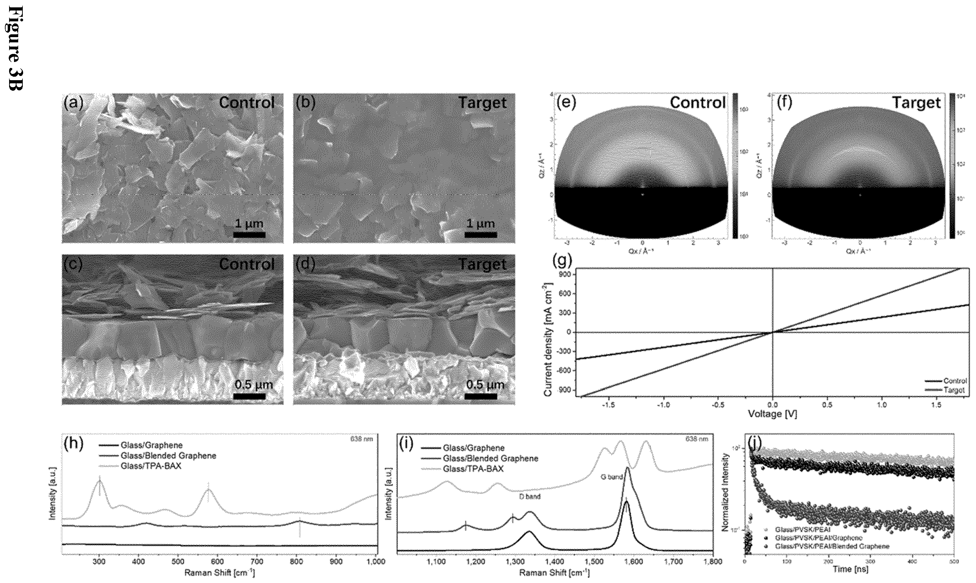

**Figure 3B** presents four SEM images of a carbon electrode (images (a)-(b)) of a PSC structure (images (c) and (d)) as illustrated in Figure 3A (n-i-p perovskite solar cell), the control carbon electrode comprising the "traditional carbon" (images (a) and (c)), i.e. the carbon material only, and the target carbon-based electrode comprising a carbon-based composite according to an embodiment (images (b) and (d)). Figure 3B further shows GIWAX patterns of the carbon electrode without any composite (image (e)), and the carbon-based electrode with the carbon-based composite (image (f)), the graphical representation (image (g)) of the current density-voltage (J-V) curves under dark condition of the carbon material (control) and the carbon-based composite (target), Raman spectra (images (h) and (i)) from 200 to 1800 cm⁻¹, the graphical representation of the time-resolved photoluminescence (TRPL) results for the perovskite, perovskite/undoped carbon (i.e. carbon material only), and perovskite/doped carbon (i.e. carbon-based composite) samples.
**Figure 3C** shows a graphical representation (image (a)) of J-V curves for reverse and forward scanning under 1 sun of two PSCs, the carbon electrode of which comprises the carbon-based composite (target) or the carbon material only (control), and a graphical representation (image (b)) of the external quantum efficiency (EQE) spectra and corresponding integrated Jsc of the two PSCs.
**Figure 4A** is graphical representation of TRPL results of perovskite films coated with a carbon material layer (i.e. undoped carbon layer) or with a carbon-based composite layer (i.e. doped carbon layer).
**Figure 4B** is graphical representation of conductivity measurement of carbon material layer (undoped carbon layer) and carbon-based composite layer (doped carbon layer).
**Figure 5A** is graphical representation J-V curves of two HTL-free perovskite solar cells, the back contact of which is either a carbon electrode or a carbon-based electrode comprising a positive charge conducting additive selected from a hole shuttle molecule (HSM), under 1 sun illumination.
**Figure 5B** is graphical representation of J-V curves of two HTL-free perovskite solar cells, the back contact of which is either a carbon electrode or a carbon-based electrode comprising a positive charge conducting additive being P3HT, under 1 sun illumination.
**Figure 5C** is graphical representation of J-V curves of two HTL-free perovskite solar cells, the back contact of which is either a carbon electrode or a carbon-based electrode comprising a positive charge conducting additive being Spiro-OMeTAD, under 1 sun illumination.

### Detailed Description of the Invention

In the following, embodiments of the invention shall be described in detail with reference to the above-mentioned figures.

In one aspect, the invention concerns a carbon-based composite comprising a carbon material, said composite acting as a selective contact for positive charges or for negative charges in a photovoltaic or an electronic device. The carbon-based composite has an electrical conductivity higher than the carbon material comprised in the carbon-based composite. The electrical conductivity of the carbon-based composite is at least twice or 2.5 times the electrical conductivity of the carbon material of the composite itself. The conductivity of a carbon-based composite is in the range from 1 × 10⁵ S/m to 1 × 10⁶ S/m.

For the purpose of the present specification, the terminology "positive charge" and "negative charge" is used herein equivalently to the terminology "hole" and "electron", respectively.

The carbon-based composite further comprises an additive selected from a positive charge conducting additive or from a negative charge conducting additive. The additive acts as an electrical conductivity enhancer. The additive is combined with the carbon material in solution. The combination of additive and carbon material necessitates that the additive and the carbon material are in solution and/or dissolved or dispersed in a solvent or a mixture of solvents. Said solvent or mixture of solvents is selected from polar solvent, apolar solvent, or a combination thereof. In particular, said solvent or mixture of solvents is selected from isopropanol, chlorobenzene, ethanol, toluene, 1,2-dichlorobenzene, ethyl acetate, or a combination thereof. The carbon material may be in the form of a suspension in one or a mixture of solvents, which is adding in the solution of additive. The concentration of the additive in the carbon-based composite is up to about 80% m/m or in the range from about 0,1% m/m to about 80.0% m/m, about 0,5% m/m to 75% m/m, about 10% m/m to 60% m/m. The mixture of the additive and the carbon material, i.e. the carbon-based composite in solvent solution may be applied on a substrate comprising a perovskite film or light-harvesting layer, by solution-based deposition methods including doctor blading, electrodeposition, spin coating, and spray coating. The as-deposited carbon-based composite layer is subsequently thermally annealed to remove solvents and to enhance the interaction between the carbon material and the additive. Thus, after thermal annealing, the carbon-based composite consists of the carbon material and the additive or of the combination of carbon material and additive. There is no grafting of the additive on the carbon material.

According to one embodiment, the additive is selected from a positive charge conducting additive. The positive charge conducting additive comprises or consist of a compound being selected from a hole shuttle molecule and/or a p-type semiconductor. A hole shuttle molecule is a chemically engineered entity that transports holes via localized redox or hopping mechanisms, primarily enhancing interfacial charge transfer in devices, whereas a p-type semiconductor is a doped bulk material where holes, as majority carriers, move through delocalized valence band states, enabling extended, long-range conduction in traditional electronic components. Hole shuttle molecule acts as hole transport material and allows to bridge the interface between the active layer (e.g. light-harvesting layer, perovskite layer) and a carbon-based electrode coated on the active layer. Hole shuttle molecule is a compound comprising one or more moieties or chemical groups selected from thiophene, arylamine, carbazole, triphenylamine, phthalocyanine, porphyrin, and/or a combination thereof. The hole shuttle molecule is selected from a compound comprising one or more moieties selected from thiophene, arylamine, carbazole, triphenylamine, and/or a combination thereof, preferably triphenylamine, arylamine, carbazole or a combination thereof. The p-type semiconductor is an organic or inorganic compound selected from Spiro-N,N,N',N'-tetra(methoxyphenyl)-benzidine)poly(3-hexylthiophene-2,5-diyl (Spiro-OMeTAD), Poly(3-hexylthiophene-2,5-diyl) (P3HT), poly(3,4-ethylenedioxythiophene (PEDOT), poly(triarylamine) (PTAA), poly[5,5'-bis(2-butyloctyl)-(2,2'-bithiophene)-4,4'-dicarboxylate-alt-5,5'-2,2'-bithiophene] (PDCBT), graphene oxide (GO), CuSCN, CuI, Cu₂O, CuO, a compound containing nitrosyl such as 2,2,6,6-tetramethyl-1-piperidinyloxy (TEMPO), 2-Azaadamantane-N-oxyl (AZADO), compounds containing tetrazolium thiolate moieties such as 5-mercapto-1-methyltetrazole ion, (4-N-benzo[c]carbazolyl-2,6-dichlorophenyl)bis(2,4,6-trichlorophenyl)methyl radical (TTM-7BCz), and/or a combination thereof. In particular, the additive being a p-type semiconductor may be selected from spiro-OMeTAD, P3HT, PEDOT, PTAA and/or a combination thereof. The additive may be also selected from a salt of a hole shuttle molecule.

According to another embodiment, the additive is selected from a negative charge conducting additive. The negative charge conducting additive comprises or consist of a compound selected from an organic n-type semiconductor or an inorganic n-type semiconductor, or a combination thereof.

In a further embodiment, the negative charge conducting additive comprises or consist of an organic compound selected from [6,6]-phenyl-C61-butyric acid methyl ester (PCBM), buckminsterfullerene (C60), fullerene derivative selected from (C60-Ih)[5,6]fullerene (C60), (C70-D5h)[5,6]fullerene (C70), and [6,6]-Phenyl C71 butyric acid methyl ester (PC70BM), from 2,9-dimethyl-4,7-diphenyl-1,10-phenanthroline (BCP), 1,3,5-tri(phenyl-2-benzimidazolyl)-benzene (TPBI), perylene bisimide derivatives, naphthalimide derivatives, gelled ring type being 2-[(2Z)-2-[[20-[[1-(Dicyanomethylidene)-3-oxoinden-2-ylidene]methyl]-12,12,24,24tetrakis(4-hexylphenyl)-5,9,17,21tetrathiaheptacyclo[13.9.0.03,13.04,11.06, 10.016,23.018,22]tetracosa-1(15),2,4(11),6(10),7,13,16(23),18(22),19-nonaen-8-yl]methylidene]-3-oxoinden-1-ylidene] propanedinitrile (ITIC), tris(pentafluorophenyl)borate (BCF), dimethylanilinium tetrakis(pentafluorophenyl) borate (N-PBA), sodium tetrapentafluorophenyl borate (Na-PBA), N,N'-dialkyl-4,4'-bipyridinium salt, viologen, N,N'-Bis(propylenedioxy)-perylene diimide (PDINN), Dipyrazino[2,3-f:2',3'-h]quinoxaline-2,3,6,7,10,11-hexacarbonitrile (HAT-CN), reduced graphene oxide (rGO), bathocuproine or 2,9-Dimethyl-4,7-diphenyl-1,10-phenanthrolin (BCP), a viologen or 4,4'-bipyridine, and a combination thereof, preferably PCBM, BCP, naphthalimide and derivatives thereof, perylene bisimide and derivatives thereof, or any combination thereof.

According to another embodiment, the negative charge conducting additive comprises or consists of an inorganic n-type semiconductor selected from a transition metal oxide, a transition metal sulfide, a MXene, a transition metal carbide, a transition metal nitride, tin oxide, titanium oxide, molybdenum oxide, tungsten oxide, zinc oxide, iron oxide, tin sulfide, titanium sulfide, molybdenum sulfide, tungsten sulfide, zinc sulfide, carbon nitride, titanium nitride, and a combination thereof. MXene is a compound of the family of two-dimensional (2D) compounds with the general formula Mₙ₊₁XₙTₓ, wherein M is selected from a group of early transition metals consisting of Sc, Y, Lu, Lr, Ti, Zr, Hf, Rf, V, Nb, Ta, Db, Cr, Mo, W, Sg, Mn, Tc, Re, and Bh, X is carbon and/or nitrogen, and T is a functional group on the surface of a MXene selected from -O-, -OH and -F, and wherein n is 1, 2, 3, or 4 and x is 1 or 2. Preferably, the inorganic n-type semiconductor is selected from tin oxide, titanium oxide, molybdenum oxide, tungsten oxide, zinc oxide, iron oxide, tin sulfide, titanium sulfide, molybdenum sulfide, tungsten sulfide, zinc sulfide, carbon nitride, titanium nitride, and a combination thereof.

The carbon material of the carbon-based composite is selected from graphene, graphite, carbon nanotubes, carbon black, amorphous carbon, and porous carbon, and a combination thereof.

According to a further aspect, the invention concerns an optoelectronic or photovoltaic device comprising a light-harvesting layer 3 comprising an organic/inorganic metal halide perovskite, and a carbon-based electrode 4 comprising a carbon-based composite. The light-harvesting layer 3 is in electric contact with and/or coated by the carbon-based electrode 4.

For the purpose of the present specification, the terminology "perovskite" is used herein equivalently to the terminology "organic/inorganic metal halide perovskite".

The expression "in electric contact with" or "in contact with" means that electrons or holes can get from one layer to the other layer with which it is in electric contact, at least in one direction. In particular, considering the electron flow in the operating device exposed to electromagnetic radiation, layers through which electrons and/or holes are flowing are considered to be in electric contact. The expression "in electric contact with" does not necessarily mean that electrons and/or holes can freely move in any direction between the layers. The expression "in electric contact with" or "in contact with" does not necessarily mean to be directly in electric contact with or in direct contact with, but "in electric contact with" may also mean to be in contact through intermediate and/or optional layer, or optional and/or intermediate layer may be present there between.

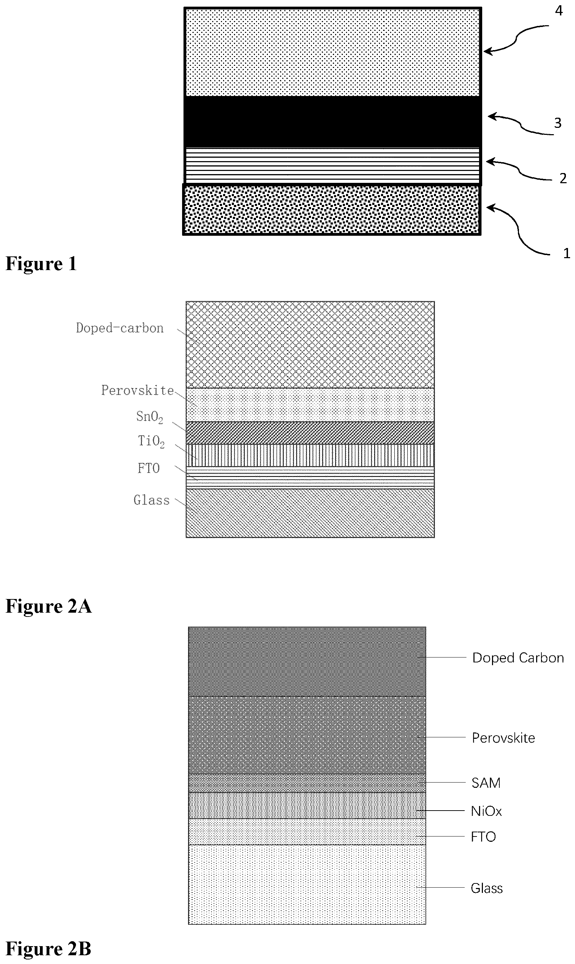

The optoelectronic or photovoltaic device further comprises a conductive support layer 1, a charge transport layer (CTL) 2, characterized in that the conductive support layer 1 is covered by and in contact with the CTL 2 being in electric contact with and/or coated by the light-harvesting layer 3. The CTL 2 comprises an electron transport material (ETM) or a hole transport material (HTM), depending on whether the carbon composite forms a selective contact for positive charges or a selective contact for negative charges, respectively. The conductive support layer 1, being transparent, is on the side of the light. As illustrated in Figure 2A, the conductive support layer 1 is in electric contact with and/or coated by an electron transport layer (ETL) and the photovoltaic device with a back contact comprising a carbon-based composite with a selectivity for the positive charges presents a n-i-p structure or configuration. In this configuration, "n" stands for an electron transporting layer (ETL), "p" represents the layer comprising a carbon-composite with a positive charge conducting additive, e.g. the back contact of the device, "I" referring to the active material, e.g. perovskite. In the configuration p-i-n as illustrated in Figure 2B, the conductive support layer 1 is in electric contact with and/or coated by a hole transport layer (HTL) and the back contact of the photovoltaic device presents a selectivity for the negative charges. In this configuration, "p" stands for a hole transport layer (HTL), "n" represents the layer comprising a carbon-composite with a negative charge conducting additive, e.g. the back contact of the device.

The conductive support layer 1 is substantially transparent. "Transparent" means transparent to at least a part, preferably a major part of the visible light. Preferably, the conductive support layer is substantially transparent to all wavelengths or types of visible light. Furthermore, the conductive support layer may be transparent to non-visible light, such as UV and IR radiation, for example. The conductive support layer provides the support layer the optoelectronic and/or photovoltaic device. The optoelectronic and/or electrochemical device may be built on said support layer.

A transparent conductor may be also provided as a top layer on the side of the back contact or carbon-based electrode. Said transparent conductor does not act as a support for the optoelectronic or photovoltaic device, since the latter can be a flexible device. The transparent conductor may comprise a conducting plastic as described herein .

The conductive support layer 1 functions and/or comprises a current collector, collecting the current obtained from the device. The conductive support layer may comprise a material selected from indium doped tin oxide (ITO), fluorine doped tin oxide (FTO), ZnO-Ga₂O₃, ZnO-Al₂O₃, tin-oxide, antimony doped tin oxide (ATO), SrGeOs and zinc oxide, preferably coated on a transparent substrate, such as plastic or glass. In this case, the plastic or glass provides the support structure of the layer and the cited conducting material provides the conductivity. Such support layers are generally known as conductive glass and conductive plastic, respectively, which are thus preferred conductive support layers in accordance with the invention. The conductive support layer 1 comprises a conducting transparent layer, which may be selected from conducting glass and from conducting plastic. Specific examples of the transparent substrate include, but are not limited to, a glass substrate, transparent inorganic substrates, such as quartz and glass; transparent plastic substrates, such as poly(ethylene terephthalate) (PET), polyethylene 2,6-naphthalate) (PEN), polycarbonate (PC), polyethylene (PE), polypropylene (PP), and polyimide (PI).

The conductive support layer 1 further comprises a metal oxide layer, preferably a compact metal oxide layer and further may comprise a mesoporous/nanoporous/nanostructured metal oxide layer being a surface-increasing scaffold structure provided onto the compact metal oxide layer. The metal oxide particles of the conductive support layer are selected from SiO₂, TiO₂, SnO₂, ZnO, Zn₂SnO₄, Nb₂O₅, WO₃, BaTiO₃ or SrTiO₃ or any combination thereof. The metal oxide particles of the compact layer and the metal oxide particles of the scaffold structure may be made of the same or different metal oxide described above.

According to a further embodiment, the CTL 2 comprises one or more electron transport material (ETM), in particular when the carbon-based composite comprised in the carbon-based electrode 4 acts as a selective contact for the positive charges. The CTL 2 may be a monolayer or a multilayer structure comprising at least one electron transport material (ETM) selected from a n-type metal oxide selected from SiO₂, TiO₂, SnO₂, ZnO, Zn₂SnO₄, Nb₂O₅, WO₃, BaTiOs or SrTiOs or any combination thereof and/or from n-type semiconducting polymers such as those described as the organic compounds of the negative charge conducting additive. The n-type metal oxide is in the form of crystalline layer or porous layers. If two or more layers are present, each layer of n-type metal oxide is of a different or identical type.

According to an embodiment, , the CTL 2 comprises one or more hole transport material (HTM), in particular when the carbon-based composite comprised in the carbon-based electrode 4 acts as a selective contact for the negative charges. The HTM is selected from inorganic p-type semiconductors selected from NiO, CuO, CuSCN, CuI, CuGaO₂, CuCrO₂, CuAlO₂, CsSnI₃, MoOs or WO₃ or any combination thereof, or from an organic p-type semiconductor such as those described as the organic p-type semiconductors of the positive charge conducting additive.

The perovskite or organic/inorganic metal halide perovskite is an organic-inorganic perovskite selected from a perovskite structure according to any one of formulae (IIa), (IIb), (IIc), or (IId), or an inorganic perovskite selected from a perovskite structure according to (IIe) below:

ABX₃ (IIa)

AA'BX₃ (IIb)

(Aₗ)ₘAA'BX₃ (IIc)

(Aₗ)ₘABX₃ (IId)

(Aₗ)ₘBX₃ (IIe)

wherein,
- A and A' are organic, monovalent cations being independently selected from primary, secondary, tertiary or quaternary organic ammonium compounds, including N-containing heteroring and ring systems, A and A' having independently from 1 to 60 carbons and 1 to 20 heteroatoms;
- A₁ is an inorganic cation selected from Li⁺, Na⁺, Tl⁺, Cs⁺, Rb⁺, K⁺, Ag⁺, Cu⁺, Au⁺ and m is an integer selected from 1 to 3, each A₁ if m >1 being different;
- B is selected from Bi²⁺, Cu²⁺, Ni²⁺, Co²⁺, Fe2+, Mn²⁺, Cr²⁺, Pd²⁺, Cd²⁺, Ge²⁺, Sn²⁺, Pb²⁺, Eu²⁺, Yb²⁺, [SnᵢPb₍₁₋ᵢ₎]⁺, [SnⱼGe₍₁₋ⱼ₎]⁺, and [PbₖGe₍₁₋ₖ₎]⁺, i, j and k being a number between 0.0 and 1.0, or an alloy thereof; and,
- X are independently selected from Br⁻, I⁻, Cl⁻, SCN⁻, CN⁻, NC⁻, OCN⁻, NCO⁻, NCS⁻, SeCN⁻, TeCN⁻, PF₆⁻, BF₄⁻ or a combination thereof.

In particular, A and A' may be independently selected from NH₄⁺, CH₃NH₃⁺, CH₃CH₂NH₃⁺, HC(NH₂)₂⁺, CH₃C(NH₂)₂⁺, C₆H₅CH₂CH₂NH₃⁺, C(NH₂)₃⁺, CH₃(CH₂)₃NH₃⁺, (CH₃)₂CHCH₂NH₃⁺, (CH₃)₄N⁺, CH₃NH₂⁺ or (CH₃)₃NH⁺. In particular, M may be selected from Bi²⁺, Cu²⁺, Ni²⁺, Co²⁺, Fe²⁺, Mn²⁺, Cr²⁺, Pd²⁺, Cd²⁺, Ge²⁺, Sn²⁺, Pb²⁺ or an alloy thereof. Preferably, X is independently selected from Cl⁻, Br⁻, and I⁻ or a combination thereof.

In a further embodiment, the optoelectronic or photovoltaic device further comprises one or more layers applied onto the light-harvesting layer or the active layer. One of layers is a passivation layer coating the organic-inorganic perovskite of the light-harvesting layer and comprising a passivation compound selected from phenylethylammonium iodide (PEAI), octylammonium iodide (OAI), isobutylammonium iodide (iBAI), sodium benzenesulfonate (NaBS), dimethylphenethylsulfonium iodide (DMPESI), aromatic ketones, and/or a combination thereof.

The optoelectronic or photovoltaic device is selected from an organic photovoltaic device, a photovoltaic solid state device, a organic/inorganic metal halide perovskite photovoltaic device, a organic/inorganic metal halide perovskite solar cell, a solar cell, a n-i-p perovskite solar cell, a p-i-n perovskite solar cell, a multi-junction photovoltaic cell comprising two or more semiconductors having different band gaps as light harvesting materials, a solar cells with at least two p-n junctions made of different semiconductor materials a phototransistor, and/or a light-emitting diode (LED). Preferably, the device is selected from a solar cell, an organic photovoltaic device, an organic/inorganic metal halide perovskite photovoltaic device, an organic/inorganic metal halide perovskite solar cell, a solar cell, a n-i-p perovskite solar cell, a p-i-n perovskite solar cell, a multi-junction photovoltaic cell and/or a LED.

In another aspect, the invention concerns a method for manufacturing an optoelectronic or photovoltaic device comprising:
- providing a conductive support layer 1;
- providing a CTL 2 onto the conductive support layer 1;
- providing a light-harvesting layer or active layer 3 onto the underlying layer;
- providing a carbon-based electrode 4 onto the underlying layer.

According to an embodiment, the step of providing the carbon-based electrode 4 comprising applying the carbon-based composite in the form of a solution, suspension or a dispersion. The carbon-based composite is applied onto the underlying layer being the active layer 3 by a method selected from spray coating, drop casting, doctor blading, spray pyrolysis, printing and/or electrodeposition. The coated substrate comprising the conductive support layer 1, the CTL 2, the active layer 3 and the carbon-based composite, is subsequently submitted to thermal annealing at a temperature in range of 60°C to 110°C, 80°C to 110°C, preferably at about 100°C. The duration of the thermal annealing is from 20 to 60 minutes, from 20 to 40 minutes, of about 30 minutes. The active layer 3 comprising an organic-inorganic perovskite as described herein may be passivated before the application of the carbon-based composite to form the carbon-based electrode.

The present invention will now be illustrated by way of examples. These examples do not limit the scope of this invention, which is defined by the appended claims.

Although the present invention has been explained in relation to its preferred embodiment, it is to be understood that many other modifications and variations can be made without departing from the scope of the invention as hereinafter claimed.

### Examples

### Example 1: preparation of organic-inorganic perovskite based device with n-i-p configuration having a doped carbon-based electrode as back contact of the device (Figure 2A)

### Materials

All materials were used as received without further purification. The spiro-OMeTAD was purchased from Xi'an Polymer Light Technology Corp. The formamidinium iodide (FAI) and methylammonium chloride (MACl) were purchased from Greatcell Solar Materials. The titanium diisopropoxide bis(acetylacetonate) was purchased from Sigma Aldrich. The lead iodide was purchased from TCI. The SnO₂ colloid solution (15% in H₂O) were purchased from Alfa Aesar.

### Preparation of substrate

Fluorine-doped tin oxide (FTO)-glass substrates (TCO glass, NSG 10, Nippon sheet glass, Japan) were etched from the edges by using Zn powder and concentrated hydrochloric acid (1 M) and then, were cleaned by ultrasonication in Hellmanex (2%, deionized water), rinsed thoroughly with de-ionized water and ethanol, and then treated in oxygen plasma for 15 min.

### Preparation of TiO₂ hole blocking layer

A 30 nm blocking layer (TiO₂) was deposited on the cleaned FTO by spray pyrolysis at 450 °C using a commercial titanium diisopropoxide bis(acetylacetonate) solution diluted in anhydrous ethanol (1:9 volume ratio) as precursor and oxygen as a carrier gas.

### Preparation of SnO₂ layer

The SnO₂ layer was deposited on the TiO₂ layer by spin coating SnO₂ colloid solution (1:4 diluted in DI water) at 4000 rpm for 30s followed by an annealing at 170°C for 30min.

### Preparation of the organic-inorganic perovskite layer

A PbI₂ solution (1.5M in mixed solvent is volume ratio of 9:1 of dimethyl formamide and dimethyl sulfoxide) was spin-coated on the substrate at 1500 rpm for 30s, followed by annealing at 70°C for 40 s. Then a FAI:MACl (formamidinium iodide:methylammonium chloride) mixed solution (90mg/mL FAI and 12mg/mL MACl in isopropanol) was spin-coated on the PbI₂ layer at 1700 rpm for 25s, followed by annealing at 90 °C for 20 s. Then, the film was further annealed at 150 °C for 15min. Then, a passivation layer was deposited by spin-coating 3mg/mL of PEAI (phenylethylammonium iodide) in isopropanol on the perovskite at 4000 rpm for 30s.

### Preparation of the carbon-based electrode

The carbon-based composite in the form of a solution or the carbon-based composite solution was prepared by mixing a carbon material in the form of a solution or a dispersion further comprising one or more solvents with an additive, being in the form of a solution comprising mixed solvents and selected from a positive charge conducting additive into a solvent. Then the as-prepared carbon-based composite in the form of a solution was deposited onto the passivated perovskite layer by spray pyrolysis.

### Example 2: perovskite solar cell with a carbon-based electrode comprising a hole shuttle molecule (HSM) doped graphene

The stack up to the perovskite layer was fabricated as described above. The carbon-based composite solution was prepared by mixing the HSM being (4-(3,6-bis(4-(bis(4-methoxyphenyl)amino)phenyl)-9H-carbazol-9-yl)benzenaminium iodide) with multilayer graphene at a ratio of 10% m/m into a mixed solvent of 1:1 v/v chlorobenzene and isopropanol. Then the carbon-base composite solution was deposited on the perovskite by spray pyrolysis at 80 °C to make a 10 µ m thick carbon layer (Figure 3A).

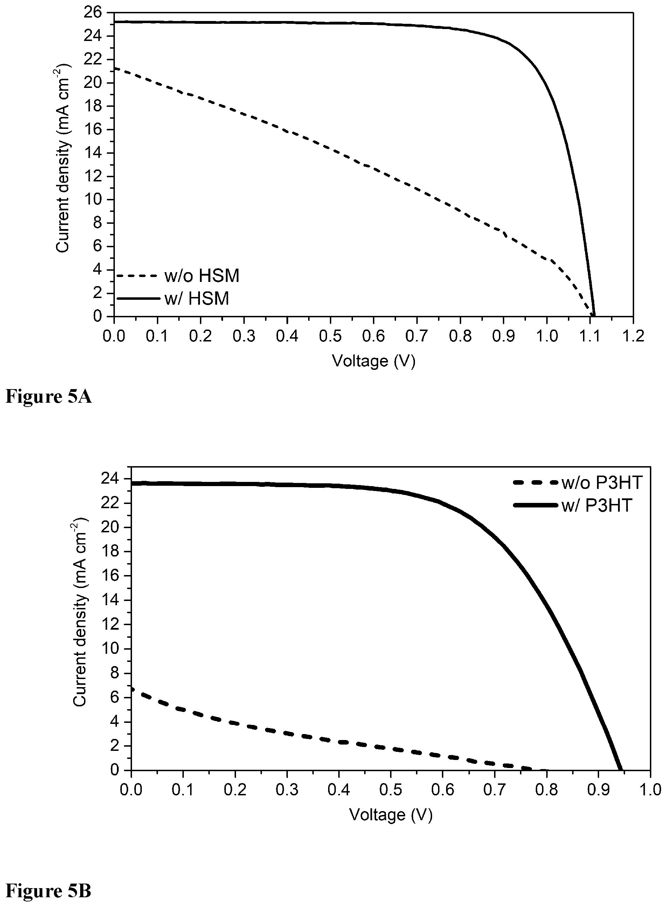

As illustrated in Figure 5A, the addition of HSM into the carbon material (graphene), the performance of the HTL-free perovskite solar cell was improved from *Voc* 1.11 V, *Jsc 21.2* mA/cm², fill factor 32.7%, PCE 7.7% (for a device without HSM in the graphene carbon electrode) to *Voc* 1.11 V, *Jsc* 25.2 mA/cm², fill factor 76.2%, PCE 21.3% .

The introduction of a hole shuttle molecule into the carbon material (graphene) has resulted in the formation of a HSM-doped carbon-based electrode material. This material, i.e. the carbon-based composite, significantly improves the hole extraction efficiency and conductivity.

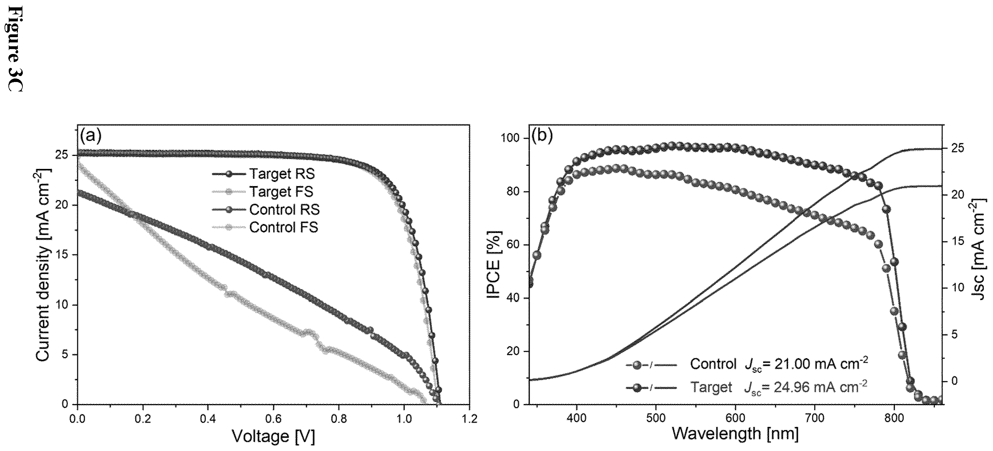

**Table 1 Photovoltaic parameters from the JV curves (Figure 3C) of the control and target PSCs measured at backward and forward scans at a scan rate of 10 mVs-1.**

| | *V*_{oc} (V) | *J*_{sc} (mA cm⁻²) | FF (%) | PCE (%) |
|---|---|---|---|---|
| Ref-RS | 1.11 | 21.24 | 32.7 | 7.67 |
| Ref-FS | 1.07 | 24.85 | 20.0 | 5.3 |
| Target-RS | 1.11 | 25.21 | 76.2 | 21.32 |
| Target-FS | 1.10 | 25.35 | 75.4 | 21.03 |

Building on this advancement, we compared the morphology of traditional (control) and new (target) carbon materials using scanning electron microscopy (SEM) (Figure 3B , images (a)-(d)). The target material exhibits a smoother and more organized morphology than the control, as confirmed by Grazing-Incidence Wide Angle X-ray Scattering (GIWAX) patterns (Figure 3B, images (e), (f)). Furthermore, the target material demonstrates excellent conductivity, with significantly lower resistance than conventional carbon electrodes (Figure 3B, image (g)). This improvement is critical for efficient hole transport.

We hypothesized that the enhanced conductivity arises from molecular interactions, which was verified through Raman spectroscopy (Figure 3B, images (h), (i)). Compared with pure graphene and HSM the blended carbon material exhibits new peaks in its Raman spectra, indicating the formation of novel molecular interactions after blending. These interactions promote charge transfer and extraction, as evidenced by the notably reduced carrier lifetime shown in Figure 3B, images (j).

Our efforts have resulted in a PCE of 21.33%, significantly outperforming the control devices (Figure 3C, image (a) and Table 1). Notably, this PCE represents the highest efficiency reported for planar HTL-free carbon-based PSCs. The EQE spectra and corresponding integrated Jsc values are shown in Figure 3C, image (b), where the calculated Jsc values are 21.00 and 24.96 mA cm⁻² for the control and target devices, respectively, aligning well with the Jsc derived from J-V curves.

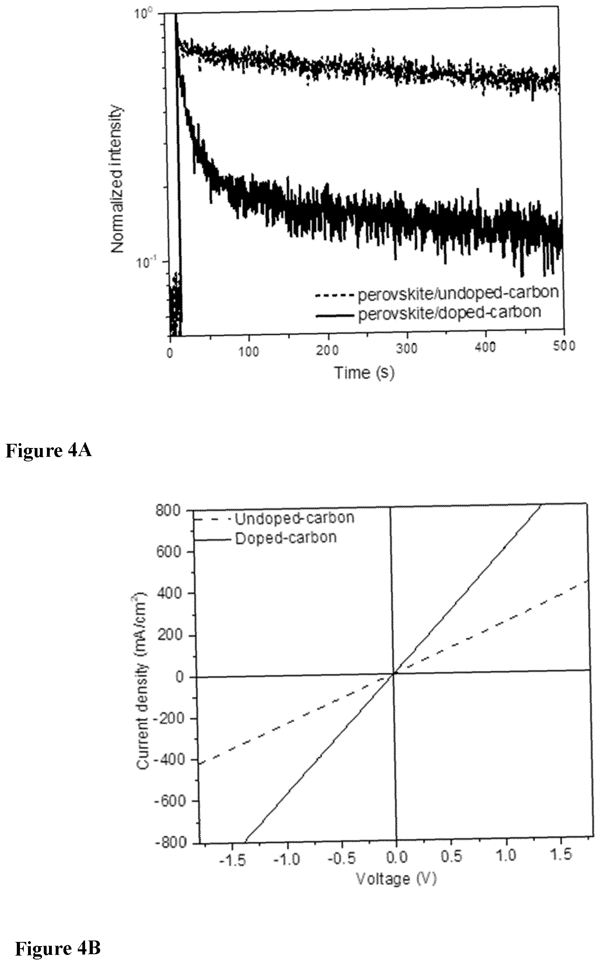

The improvements achieved with the doped-carbon electrode stem from enhanced carrier selectivity, as evidenced by the time-resolved photoluminescence (TRPL) measurements in Figure 4A and increased conductivity, as demonstrated by the conductivity measurements in Figure 4B. In Figure 4A, the TRPL curve of the perovskite/doped-carbon sample shows a much faster decay within the first ~100 ns, strongly indicating that hole injection at the perovskite/doped-carbon interface is significantly faster than at the perovskite/undoped-carbon interface, suggesting improved hole selectivity. In addition, Figure 4B illustrates that the slope of the J-V curve for the doped-carbon layer is twice that of the undoped-carbon layer, signifying that the resistance is reduced to half of its original value. This substantial decrease in resistance further highlights the effectiveness of the doped-carbon electrode in enhancing device performance.

In summary, we have developed a novel carbon electrode material for planar HTL-free carbon-based PSCs. The newly formed interactions between molecules and carbon significantly enhance charge extraction, achieving the highest efficiency ever reported for this type of PSC.

### Example 3: perovskite solar cell with a carbon-based electrode comprising a P3HT-doped graphene

The stack up to the perovskite layer was fabricated as described above. The carbon-based composite solution was prepared by mixing P3HT with multilayer graphene at a ratio of 30% m/m into a mixed solvent of 1: 1 v/v chlorobenzene and isopropanol. Then the carbon solution was deposited on the perovskite by spray pyrolysis at 100 °C to make a 10 µ m thick carbon-based electrode.

The addition of the positive charge conducting additive P3HT in the carbon material of the electrode, the performance of the HTL-free perovskite solar cell was improved from *Voc* 0.78 V, *Jsc* 6.7 mA/cm², fill factor 18.2%, PCE 0.93% for a device without doping the carbon material to *Voc* 0.94 V, *Jsc* 23.0 mA/cm², fill factor 61.0%, PCE 13.2% (Figure 5B)

### Example 4: perovskite solar cell with a carbon-based electrode comprising a Spiro-OMeTAD-doped graphene

The stack up to the perovskite layer was fabricated as described above. The carbon-based composite solution was prepared by mixing Spiro-OMeTAD with carbon powder at a ratio of 30% m/m into a mixed solvent of 1:1 v/v chlorobenzene and isopropanol. Then the carbon solution was deposited on the perovskite by spray pyrolysis at 100 °C to make a 10 µ m thick carbon-based electrode.

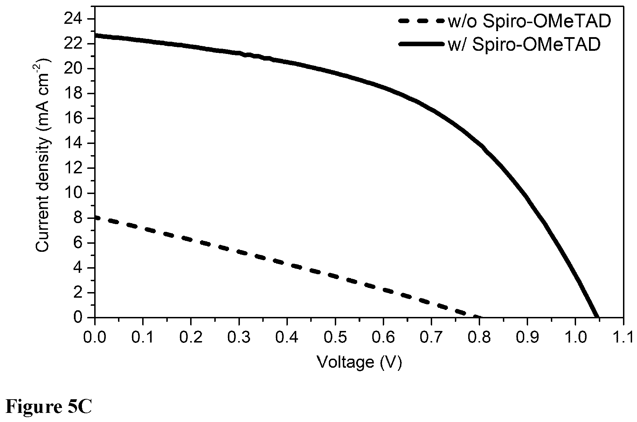

The photovoltaic parameters of the HTL-free perovskite solar cell with graphene electrode are *Voc* 0.79 V, *Jsc* 8.0 mA/cm², fill factor 26.9%, PCE 1.70% in contrast with the photovoltaic parameters of the perovskite-based device comprising a carbon-based composite with Spiro-OMeTAD as back contact, said parameters being *Voc* 1.05 V, *Jsc* 22.9 mA/cm², fill factor 49.4%, PCE 11.5% (Figure 5C).

## Claims

1. A carbon-based composite comprising a carbon material, said composite acting as a selective contact for positive charges or for negative charges in a photovoltaic or an electronic device.

2. The carbon-based composite according to any one of the preceding claims, wherein the composite has electrical conductivity that is at least twice or at least 2.5 times the electrical conductivity of the carbon material comprised in the composite.

3. The carbon-based composite according to any one of the preceding claims, further comprising an additive selected from a positive charge conducting additive or from a negative charge conducting additive.

4. The carbon-based composite according to claim 3, wherein the additive acts as an electrical conductivity enhancer.

5. The carbon-based composite according to any one of claims 3-4 comprising up to about 80% m/m of additive.

6. The carbon-based composite according to any one of claims 2-5, wherein the positive charge conducting additive comprises a compound selected from a hole shuttle molecule comprising one or more moieties selected from thiophene, arylamine, carbazole, triphenylamine, phthalocyanine, porphyrin, and a combination thereof.

7. The carbon-based composite according to any one of claims 2-5, wherein the positive charge conducting additive comprises a p-type semiconductor selected from Spiro-N,N,N',N'-tetra(methoxyphenyl)-benzidine)poly(3-hexylthiophene-2,5-diyl (Spiro-OMeTAD), Poly(3-hexylthiophene-2,5-diyl) (P3HT), poly(3,4-ethylenedioxythiophene (PEDOT), poly(triarylamine) (PTAA), poly [5,5'-bis(2-butyloctyl)-(2,2'-bithiophene)-4,4'-dicarboxylate-alt-5,5'-2,2'-bithiophene] (PDCBT), graphene oxide (GO), Cu(SCN), CuI, Cu₂O, CuO, a compound containing nitrosyl such as 2,2,6,6-tetramethyl-1-piperidinyloxy (TEMPO), 2-Azaadamantane-N-oxyl (AZADO), compounds containing tetrazolium thiolate moieties such as 5-mercapto-1-methyltetrazole ion, (4-N-benzo[c]carbazolyl-2,6-dichlorophenyl)bis(2,4,6-trichlorophenyl)methyl radical (TTM-7BCz), and a combination thereof.

8. The carbon-based composite according to any one of claims 2-5, wherein the negative charge conducting additive comprises an organic compound selected from [6,6]-phenyl-C61-butyric acid methyl ester (PCBM), buckminsterfullerene (C60), fullerene derivative selected from (C60-Ih)[5,6]fullerene (C60), (C70-D5h)[5,6]fullerene (C70), and [6,6]-Phenyl C71 butyric acid methyl ester (PC70BM), from 2,9-dimethyl-4,7-diphenyl-1,10-phenanthroline (BCP), 1,3,5-tri(phenyl-2-benzimi-dazolyl)-benzene (TPBI), perylene bisimide derivatives, naphthalimide derivatives, gelled ring type being 2-[(2Z)-2-[[20-[[1-(Dicyanomethylidene)-3-oxoinden-2-ylidene]methyl]-12,12,24,24tetrakis(4-hexylphenyl)-5,9,17,21tetrathiaheptacyclo[13.9.0.03,13.04,11.06,10.016,23.018,22] tetracosa-1(15),2,4(11),6(10),7,13,16(23),18(22),19-nonaen-8-yl]methylidene]-3-oxoinden-1-ylidene] propanedinitrile (ITIC) , tris(pentafluorophenyl)borate (BCF), dimethylanilinium tetrakis(pentafluorophenyl) borate (N-PBA), sodium tetrapentafluorophenyl borate (Na-PBA), N,N'-dialkyl-4,4'-bipyridinium salt, viologen, N,N'-Bis(propylenedioxy)-perylene diimide (PDINN), Dipyrazino[2,3-f:2',3'-h]quinoxaline-2,3,6,7,10,11-hexacarbonitrile (HAT-CN), reduced graphene oxide (rGO), bathocuproine or 2,9-Dimethyl-4,7-diphenyl-1,10-phenanthrolin (BCP), a viologen or 4,4'-bipyridine, 2,3,5,6-Tetrafluoro-tetracyanoquinodimethane (F4-TCNQ) and a combination thereof.

9. The carbon-based composite according to any one of claims 2-5, wherein the negative charge conducting additive comprises an inorganic n-type semiconductor selected from tin-oxide, titanium-oxide, molybdenum-oxide, tungsten-oxide, zinc-oxide, tin-sulfide, titanium- sulfide, molybdenum-sulfide, tungsten- sulfide, zinc-sulfide, carbon-nitride, titanium-nitride, and a combination thereof.

10. The carbon-based composite according to any one of the preceding claims, wherein the carbon material is selected from graphene, graphite, carbon nanotubes, carbon black, amorphous carbon, and porous carbon.

11. An optoelectronic or photovoltaic device comprising a light-harvesting layer (3) comprising an organic/inorganic metal halide perovskite, and a carbon-based electrode (4) comprising a carbon-based composite according to any one of claims 1-10.

12. The optoelectronic or photovoltaic device according to claim 11, **characterized in that** the light-harvesting layer (3) is in electric contact with and/or coated by the carbon-based electrode (4).

13. The optoelectronic or photovoltaic device according to any one of claims 11-12 further comprises a conductive support layer (1), a charge transport layer (CTL) (2), **characterized in that** the conductive support layer (1) is covered by and in contact with the CTL (2) being in electric contact with and/or coated by the light-harvesting layer (3) and **in that** the CTL (2) comprises an electron transport material (ETM) or a hole transport material (HTM).

14. The optoelectronic or photovoltaic device according to any one of claims 11-13, wherein the organic/inorganic metal halide perovskite is an organic-inorganic perovskite selected from a perovskite structure according to any one of formulae (IIa), (IIb), (IIc), or (IId), or an inorganic perovskite selected from a perovskite structure according to (IIe) below:
ABX₃ (IIa)
AA'BX₃ (IIb)
(Aₗ)ₘAA'BX₃ (IIc)
(Aₗ)ₘABX₃ (IId)
(Aₗ)ₘBX₃ (IIe)
wherein,
- A and A' are organic, monovalent cations being independently selected from primary, secondary, tertiary or quaternary organic ammonium compounds, including N-containing heteroring and ring systems, A and A' having independently from 1 to 60 carbons and 1 to 20 heteroatoms;
- A₁ is an inorganic cation selected from Li⁺, Na⁺, Tl⁺, Cs⁺, Rb⁺, K⁺, Ag⁺, Cu⁺, Au⁺ and m is an integer selected from 1 to 3, each A₁ if m >1 being different;
- B is selected from Bi²⁺, Cu²⁺, Ni²⁺, Co²⁺, Fe2+, Mn²⁺, Cr²⁺, Pd²⁺, Cd²⁺, Ge²⁺, Sn²⁺, Pb²⁺, Eu²⁺, Yb²⁺, [SnᵢPb₍₁₋ᵢ₎]⁺, [SnⱼGe₍₁₋ⱼ₎]⁺, and [PbₖGe₍₁₋ₖ₎]⁺, i, j and k being a number between 0.0 and 1.0, or an alloy thereof; and,
- X are independently selected from Br⁻, I⁻, Cl⁻, SCN⁻, CN⁻, NC⁻, OCN⁻, NCO⁻, NCS⁻, SeCN⁻, TeCN⁻, PF₆⁻, BF₄⁻ or a combination thereof.

15. The optoelectronic or photovoltaic device according to any one of claims 11-14 being selected from an organic photovoltaic device, a photovoltaic solid state device, a organic/inorganic metal halide perovskite photovoltaic device, a organic/inorganic metal halide perovskite solar cell, a solid state solar cell, a n-i-p perovskite solar cell, a p-i-n perovskite solar cell, a multi-junction photovoltaic cell comprising two or more semiconductors having different band gaps as light harvesting materials, a solar cells with at least two p-n junctions made of different semiconductor materials a phototransistor, and a light-emitting diode (LED).
